# EUROPEAN PATENT APPLICATION

(11) **EP 2 830 224 A1**
(43) Date of publication of application: **28.01.2015**
(21) Application number: 14175650.2
(22) Date of filing: 03.07.2014
(51) Int. Cl.: H03L 7/18

(54) **PLL Device**

(30) Priority: 24.07.2013 JP 2013153500
(71) Applicant: FUJITSU LIMITED, Kawasaki-shi, Kanagawa 211-8588 (JP)
(72) Inventor: Suzuki, Toshihide, Kawasaki-shi,, Kanagawa 211-8588 (JP); Matsumura, Hiroshi, Kawasaki-shi,, Kanagawa 211-8588 (JP)
(74) Representative: Lewin, David Nicholas

(57) **Abstract**

A PLL device includes a variable frequency oscillator and a frequency divider section. The variable frequency oscillator varies an oscillation frequency in response to a control signal including information on a phase difference between a reference signal and a frequency division signal and oscillates an output signal obtained by multiplying a frequency of the reference signal. The frequency divider section frequency-divides the output signal to generate the frequency division signal. An locked frequency divider is arranged in the frequency divider section, the control signal is input to the injection locked frequency divider, and the operation frequency of the injection locked frequency divider is controlled by the control signal.

## Description

### FIELD

The embodiments discussed herein relate to a PLL (Phase Locked Loop) device.

### BACKGROUND

In the communication apparatuses, such as a wireless communication apparatus, a PLL circuit is used, for example, in order to generate a high frequency carrier signal in a millimeter waveband or the like.

The PLL circuit is a circuit for feedback-controlling an oscillator inside a loop to oscillate so that the phase difference between a reference signal coming from the outside and the output from the oscillator becomes constant and thereby obtaining an oscillation output in synchronization with the reference signal. Moreover, in the PLL circuit, a frequency divider circuit is used for frequency-dividing the output signal from an oscillator and feeding back and inputting the resulting signal to a phase comparator.

As the conventional art, there is proposed a PLL circuit employing an injection locked frequency divider.

Please see, for example, Japanese Laid-open Patent Publication No. 2007-208589.

As one of the frequency divider circuits, an injection locked frequency divider is known. However, because the frequency range of a self-oscillation frequency of the injection locked frequency divider is narrow, when an injection locked frequency divider with a non-adjusted oscillation frequency is used for the PLL circuit, there is a problem that a wideband operation is not achieved.

### SUMMARY

According to an aspect of the embodiments disclosed herein, there is provided a PLL device including: a variable frequency oscillator configured to vary an oscillation frequency in response to a control signal including information on a phase difference between a reference signal and a frequency division signal and oscillate an output signal obtained by multiplying a frequency of the reference signal; and a frequency divider section configured to frequency-divide the output signal to generate the frequency division signal, wherein an injection locked frequency divider is arranged in the frequency divider section, the control signal is input to the injection locked frequency divider, and an operation frequency of the injection locked frequency divider is controlled by the control signal.

### BRIEF DESCRIPTION OF DRAWINGS

FIG. 1 illustrates an example of a PLL device of an embodiment;
FIG. 2 illustrates a first comparative example of a PLL circuit;
FIG. 3 illustrates an example of an injection locked frequency divider;
FIG. 4 illustrates a second comparative example of the PLL circuit;
FIG. 5 illustrates an example of the PLL circuit of the embodiment;
FIG. 6 illustrates a circuit example of the injection type frequency divider in the PLL circuit of the embodiment;
FIG. 7 illustrates an example of the relationship between the voltage of a control signal and a frequency;
FIG. 8 illustrates a first variant of the PLL circuit of the embodiment; and
FIG. 9 illustrates a second variant of the PLL circuit of the embodiment.

### DESCRIPTION OF EMBODIMENTS

Several embodiments will be described below with reference to the accompanying drawings, wherein like reference numerals refer to like elements throughout.

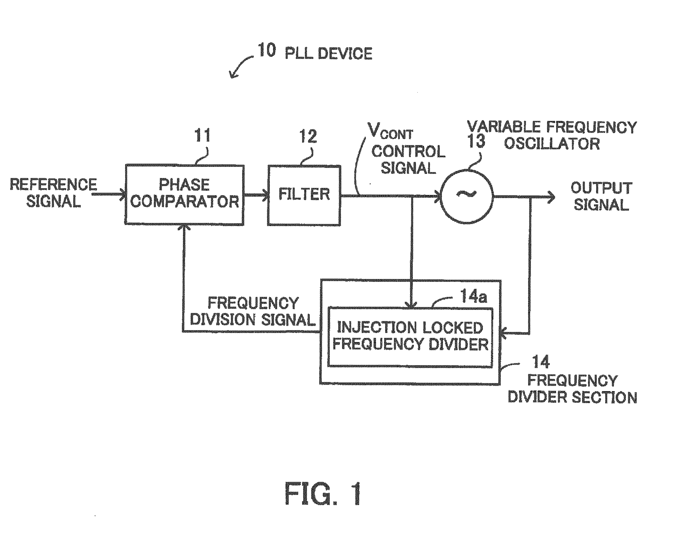

FIG. 1 illustrates an example of a PLL device of an embodiment.

A PLL device 10 includes a phase comparator 11, a filter 12, a variable frequency oscillator 13, and a frequency divider section 14.

The phase comparator 11 performs phase comparison between a reference signal and a frequency division signal, and generates and outputs a phase difference signal. The filter 12 smoothes the phase difference signal to generate a control signal V_{CONT}.

The variable frequency oscillator 13 varies an oscillation frequency in response to the control signal V_{CONT} including information on a phase difference between the reference signal and the frequency division signal and oscillates an output signal obtained by multiplying the frequency of the reference signal. The frequency divider section 14 frequency-divides the output signal fed back from the variable frequency oscillator 13 to generate the frequency division signal.

Here, in the frequency divider section 14, there is arranged an injection locked frequency divider 14a configured to perform a frequency dividing operation while fixing the phase by injection locking of an external signal. Moreover, the control signal V_{CONT} is input to the injection locked frequency divider 14a to control the operation frequency (oscillation frequency) of the injection locked frequency divider 14a by the control signal V_{CONT}.

In this manner, in the PLL device 10, the injection locked frequency divider 14a is arranged in the frequency divider section 14, and the control signal V_{CONT} input to the oscillation frequency of the variable frequency oscillator 13 is also input to the injection locked frequency divider 14a to control the operation frequency of the injection locked frequency divider 14a. Thus, the operation frequency of the injection locked frequency divider 14a may be expanded, so that a wideband PLL operation may be achieved.

Next, a flow of the design of the PLL device according to the present technology is described in detail.

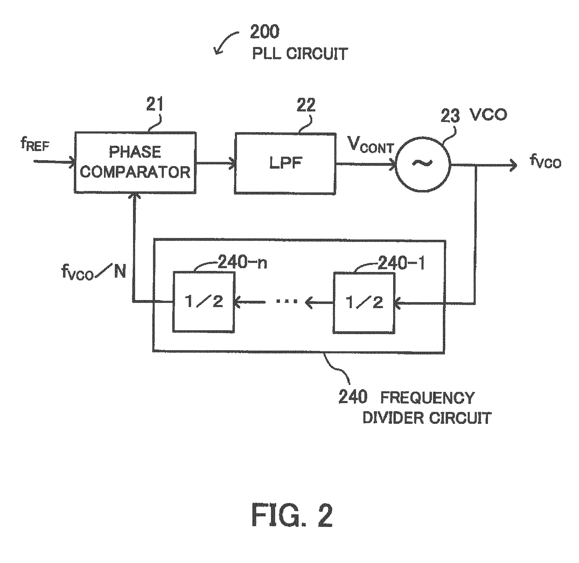

FIG. 2 illustrates a first comparative example of the PLL circuit.

A PLL circuit 200 includes a phase comparator 21, an LPF (Low Pass Filter) 22, a VCO (Voltage Controlled Oscillator) 23, and a frequency divider circuit 240.

The phase comparator 21 receives a reference signal f_{REF} and a frequency division clock fvco/N output from the frequency divider circuit 240, and performs phase comparison between these two signals and outputs a phase difference component as a pulse-like phase difference signal. The LPF 22 smoothes the phase difference signal to generate the control signal V_{CONT} (DC voltage).

The VCO 23 oscillates an output signal f_{vco} of a frequency proportional to a level value of the input control signal V_{CONT}. The frequency divider circuit 240 includes 1/2 frequency dividers 240-1 to 240-n connected in multi stages, divides the frequency of the output signal fvco fed back from the VCO 23 into 1/N to generate the frequency division clock f_{vco}/N, and inputs the same to the phase comparator 21. Note that, if the frequency of the reference signal f_{REF} is f_{ref}, the frequency of the output signal fvco of the VCO 23 is f_{ref}×_{N}.

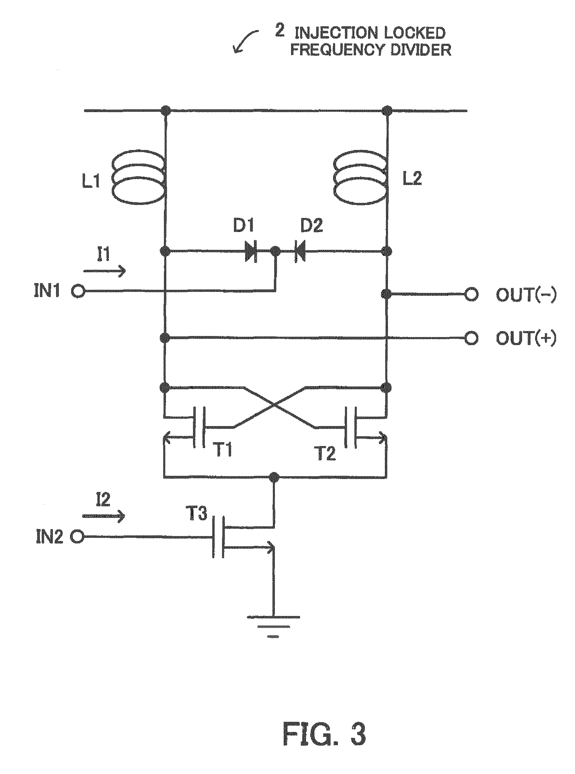

FIG. 3 illustrates an example of the injection locked frequency divider.

The injection locked frequency divider 2 includes inductors L1 and L2, diodes D1 and D2, and transistors T1 to T3 that are N-channel MOS FETs (Metal Oxide Semiconductor Field Effect Transistors).

Note that, the inductors L1 and L2, the diodes D1 and D2, and the transistors T1 and T2 form an oscillation section, and the transistor T3 serves as a switch element. Moreover, the diodes D1 and D2 are variable capacitance diodes (varactor diodes).

Here, the inductors L1 and L2 and the diodes D1 and D2 form an LC oscillator circuit. Moreover, in the LC oscillator circuit, because a loss resistance is created by the resistance components of L and C, a negative resistance for cancelling the loss resistance is added in order to continue the oscillation by LC resonance. Therefore, the negative resistance is created by the cross-coupled transistors T1 and T2 to keep the oscillation state constant.

As the connection configuration of the respective elements, one end of the inductor L1 is connected to one end of the inductor L2 and a power supply line. Another end of the inductor L1 is connected to the anode of the diode D1, a differential output terminal OUT(+), the drain of the transistor T1, and the gate of the transistor T2.

Another end of the inductor L2 is connected to the anode of the diode D2, a differential output terminal OUT(-), the drain of the transistor T2, and the gate of the transistor T1. The cathode of the diode D1 is connected to the cathode of the diode D2 and an input terminal IN1.

The source of the transistor T1 is connected to the source of the transistor T2 and the drain of the transistor T3. The gate of the transistor T3 is connected to an input terminal IN2, and the source of the transistor T3 is connected to GND.

In the above-described injection locked frequency divider 2, a differential type oscillator circuit is formed and the setting of the oscillation frequency is controlled by an input signal I1 that is applied to the common cathode connection point of the diodes D1 and D2 through the input terminal IN1.

Moreover, the differential outputs are connected to each other by the switching operation of the transistor T3. In this case, when an input signal I2 is input to the transistor T3 through the input terminal IN2, the transistor T3 is turned on to connect the differential outputs to each other.

Then, the output terminal OUT(+) and the output terminal (-) have the same potential, and an output of 1/2 the frequency (a frequency division signal of 1/2 the frequency) in synchronization with the input signal I1 is obtained by injection locking.

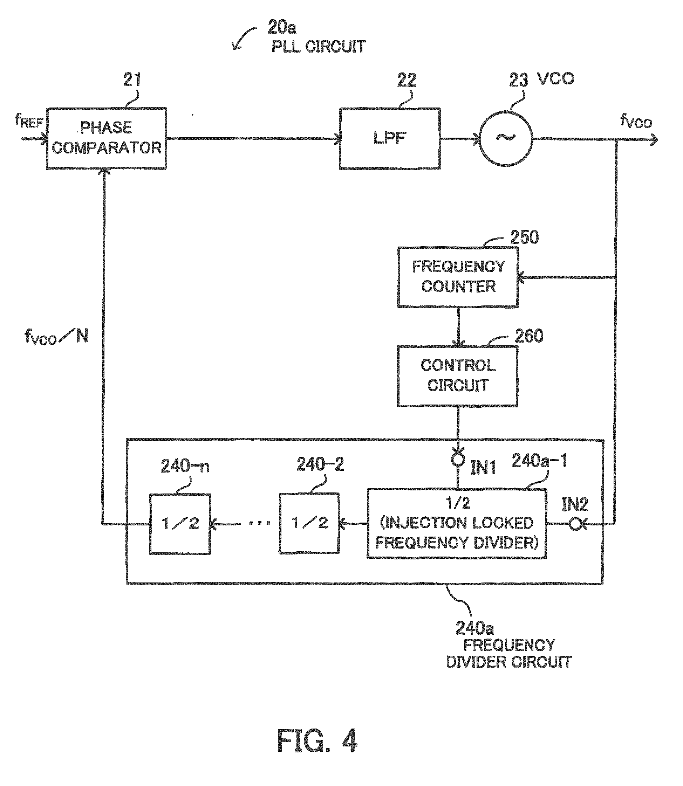

FIG. 4 illustrates a second comparative example of the PLL circuit. An example of the PLL circuit using the injection locked frequency divider 2 of FIG. 3 is illustrated.

A PLL circuit 20a includes a phase comparator 21, an LPF 22, a VCO 23, a frequency divider circuit 240a, a frequency counter 250, and a control circuit 260. Note that, the same element as the element of the PLL circuit 200 illustrated in FIG. 2 is attached with the same reference numeral, and the description thereof is omitted.

In the PLL circuit 20a, an element different from the element in the PLL circuit 200 illustrated in FIG. 2 is an injection locked frequency divider 240a-1 in place of the 1/2 frequency divider circuit 240-1 in the first stage of the frequency divider circuit. Furthermore, the frequency counter 250 and the control circuit 260 are added.

A setting signal of the oscillation frequency output from the control circuit 260 is input to the input terminal IN1 of the injection locked frequency divider 240a-1. Moreover, the output signal from the VCO 23 is input to the input terminal IN2 of the injection locked frequency divider 240a-1.

The frequency counter 250 counts the frequency of the output signal of the VCO 23 to detect the oscillation frequency of the VCO 23. The control circuit 260 generates an oscillation frequency setting signal for setting the oscillation frequency detected by the frequency counter 250 to the injection locked frequency divider 240a-1, and applies the oscillation frequency setting signal to the injection locked frequency divider 240a-1.

The injection locked frequency divider 240a-1 performs an oscillation operation by following (in synchronization with) the oscillation frequency setting signal, and outputs to the frequency divider circuit 240-2 the frequency division signal obtained by dividing the frequency of the output signal of the VCO 23 into 1/2.

In this manner, in the PLL circuit 20a, the operation frequency of the PLL circuit 20a is detected by the frequency counter 250, and the control circuit 260 generates the oscillation frequency setting signal for setting this operation frequency to the injection locked frequency divider 240a-1. Then, the oscillation frequency setting signal is input to the injection locked frequency divider 240a-1 to set the oscillation frequency, and the frequency division output is thus obtained.

Although such a PLL circuit 20a may expand the operation frequency of the injection locked frequency divider and give the output. However, because the frequency counter 250 and the control circuit 260 are added to perform frequency division control, the circuit configuration becomes complicated and the circuit size also increases.

Next, a PLL device according to the present technology is described.

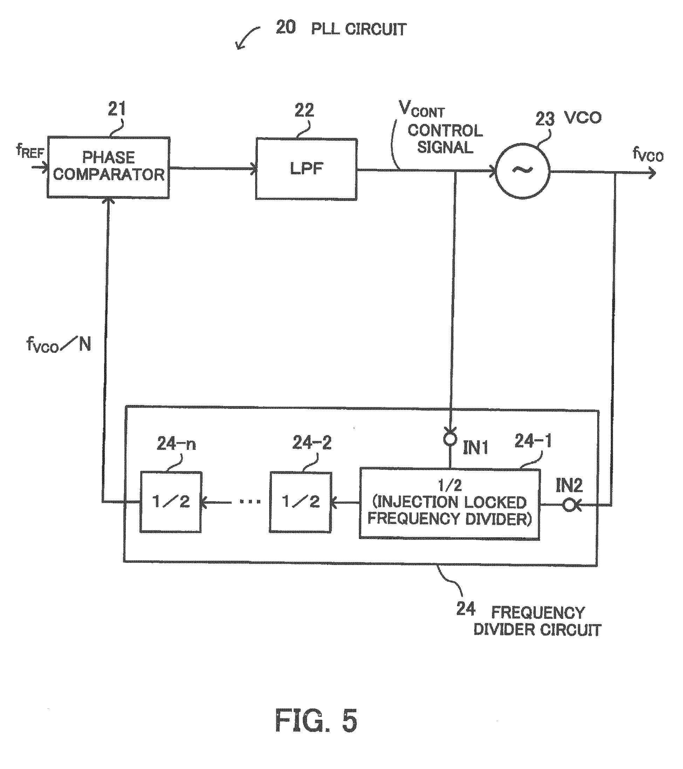

FIG. 5 illustrates an example of the PLL circuit of the embodiment. A PLL circuit 20 having the function of the PLL device 10 of FIG. 1 includes the phase comparator 21, the LPF 22, the VCO 23, and a frequency divider circuit 24. Note that, the same element as the element of the PLL circuit 200 illustrated in FIG. 2 is attached with the same reference numeral, and the description thereof is omitted.

The PLL circuit 20 differs from the PLL circuit 200 illustrated in FIG. 2 in that in the PLL circuit 20 the 1/2 frequency divider 240-1 in the first stage of the frequency divider circuit is replaced with an injection locked frequency divider 24-1.

The control signal V_{CONT} output from the LPF 22 is input to the input terminal IN1 of the injection locked frequency divider 24-1. Moreover, the output signal from the VCO 23 is input to the input terminal IN2 of the injection locked frequency divider 24-1.

In this manner, in the PLL circuit 20, the control signal V_{CONT} generated via the LPF 22 from the phase comparator 21, the control signal V_{CONT} controlling the oscillation frequency of the VCO 23, is input not only to the VCO 23 but also to the injection locked frequency divider 24-1.

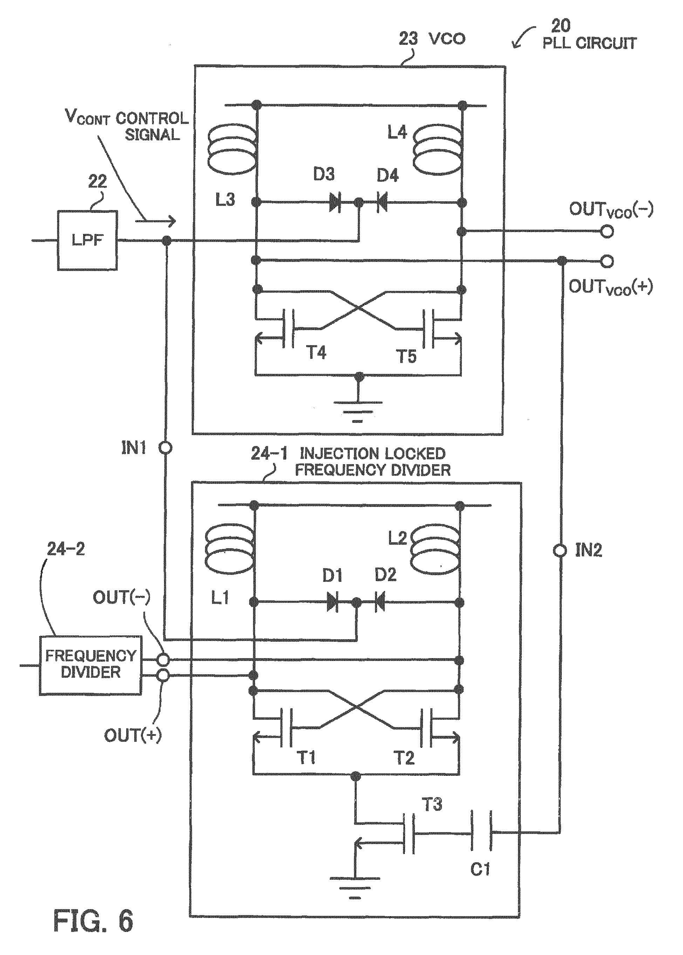

FIG. 6 illustrates a circuit example of the injection type frequency divider in the PLL circuit of the embodiment. A circuit example of the VCO 23 and the injection locked frequency divider 24-1 in the PLL circuit 20 and an example of the peripheral connection are illustrated.

The injection locked frequency divider 24-1 includes the inductors L1 and L2, diodes D1 and D2, transistors T1 to T3 (N-channel MOS FETs), and a capacitor C1 for DC (Direct Current) cut. Moreover, The VCO 23 includes inductors L3 and L4, diodes D3 and D4, and transistors T4 and T5. Note that, the transistors T1, T2, and T3 correspond to the first, second, and third transistors, respectively.

The relation of connection between the respective elements is described. One end of the inductor L3 is connected to one end of the inductor L4 and the power supply line. The other end of the inductor L3 is connected to the anode of the diode D3, an output terminal OUT_{vco}(+), one end of the capacitor C1, the drain of the transistor T4, and the gate of the transistor T5.

The other end of the inductor L4 is connected to the anode of the diode D4, an output terminal OUT_{vco}(-), the drain of the transistor T5, and the gate of the transistor T4.

The sources of the transistors T4 and T5 are connected to GND. The output terminal of the LPF 22 is connected to the cathode of the diode D3 and the cathode of the diode D4. Furthermore, the output terminal of the LPF 22 is connected to the cathode of the diode D1 and the cathode of the diode D2 via the input terminal IN1.

On the other hand, one end of the inductor L1 is connected to one end of the inductor L2 and the power supply line. The other end of the inductor L1 is connected to the anode of the diode D1, one input terminal of a frequency divider 24-2 via the output terminal OUT(+), the drain of the transistor T1, and the gate of the transistor T2.

The other end of the inductor L2 is connected to the anode of the diode D2, the other input terminal of the frequency divider 24-2 via the output terminal OUT(-), the drain of the transistor T2, and the gate of the transistor T1.

The source of the transistor T1 is connected to the source of the transistor T2 and the drain of the transistor T3. The gate of the transistor T3 is connected to the other end of the capacitor C1, and the source of the transistor T3 is connected to GND.

Next, the variable operation of the operation frequency of the injection locked frequency divider 24-1 is described.

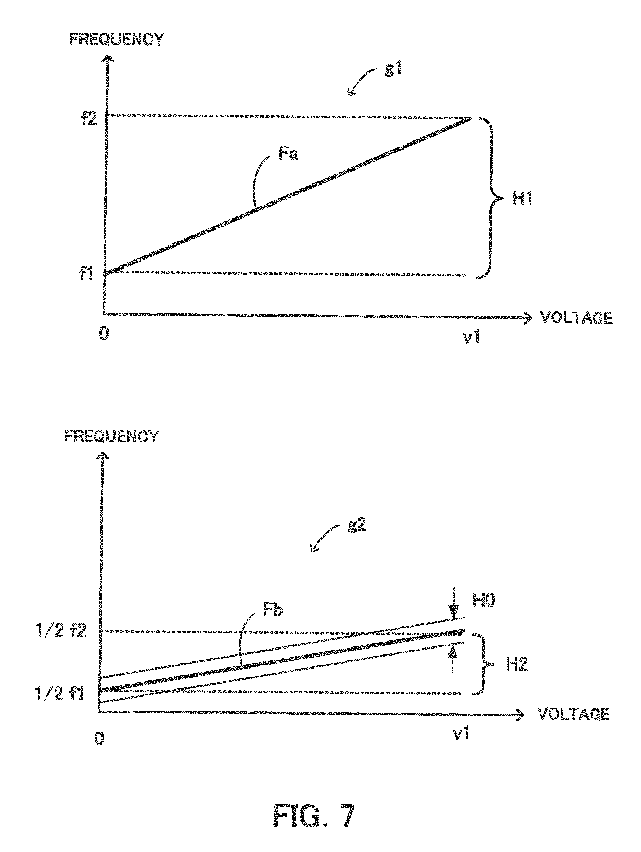

FIG. 7 illustrates an example of the relationship between the voltage of the control signal and the frequency. The vertical axis represents frequency and the horizontal axis represents the voltage of the control signal V_{CONT}.

A graph g1 illustrates the output frequency of the VCO 23, and a graph g2 illustrates the output frequency of the injection locked frequency divider 24-1.

In the graph g1, as the voltage of the control signal V_{CONT} varies from 0 to v1, the value of an output frequency Fa of the VCO 23 varies in a range H1 from a frequency f1 to a frequency f2.

In the graph g2, a range H0 indicates the range of the output frequency when the oscillation frequency of the injection locked frequency divider is not adjusted. It may be understood that the range of the self-oscillation frequency of the injection locked frequency divider without frequency adjustment is very narrow even as compared with the output frequency range of the VCO 23.

In contrast, in the present technology, the operation frequency range of the injection locked frequency divider is expanded. In this case, first, the variable capacitance of each of the diodes D1 and D2 in the injection locked frequency divider 24-1 is set to an appropriate value.

Then, the control signal V_{CONT} output from the LPF 22 is input to the common cathode connection point of the diodes D1 and D2 of the injection locked frequency divider 24-1 to synchronize the self-oscillation frequency of the injection locked frequency divider 24-1 with the oscillation frequency of the VCO 23.

The variable capacitance is set so that the injection locked frequency divider 24-1 oscillates at an operation frequency at which the ratio of an output frequency change per unit voltage of the VCO 23 to an operation frequency change per unit voltage of the injection locked frequency divider 24-1 is in a proportional relation to the frequency division ratio of the injection locked frequency divider 24-1.

That is, the output frequency change per unit voltage of the VCO 23 is denoted as Δfa, the operation frequency change per unit voltage of the injection locked frequency divider 24-1 as Δfb, and the frequency division ratio of the injection locked frequency divider 24-1 as N. Further, the variable capacitance of each of the diodes D1 and D2 is set so that the proportional relation of Δfa/Afb=a×N ("a" is the proportional constant) is established when the control signal V_{CONT} is input.

For example, when the proportional constant is set to one, the output frequency change of the VCO 23 is set to 1 GHz/V, and the frequency division ratio of the injection locked frequency divider 24-1 is set to two (1/2 frequency division), then 1 GHz/Δfb=2. Therefore, the output frequency change Δfb of the injection locked frequency divider 24-1 is 0.5 GHz/V.

Accordingly, in inputting the control signal V_{CONT} to the injection locked frequency divider 24-1, the capacitance of each of the varactor diodes D1 and D2 is set so that the output frequency change of the injection locked frequency divider 24-1 becomes 0.5 GHz/V when the output frequency change of the VCO 23 is 1 GHz/V.

In this manner, the oscillation frequency of the injection locked frequency divider 24-1 is adjusted with the control signal V_{CONT} output from the LPF 22. Thus, as illustrated in the graph g2, the value of the output frequency Fb of the injection locked frequency divider 24-1 varies in a range H2 from a frequency 1/2×f1 to a frequency 1/2xf2 as the voltage of the control signal V_{CONT} varies from 0 to v1. Therefore, the frequency range may be expanded significantly from the range H0 without adjustment.

In this manner, the control signal V_{CONT} output from the LPF 22 is input to both the varactor diodes of the frequency control section of the VCO 23 and the varactor diodes of the self-oscillation frequency control section of the injection locked frequency divider 24-1.

By appropriately setting the capacitance value of each of the varactor diodes of the injection locked frequency divider 24-1, the ratio of the frequency change of the VCO 23 to the operation frequency change of the injection locked frequency divider 24-1 may be set in the proportional relation to the frequency division ratio. Moreover, in the PLL circuit 20, because the frequency counter 250 and the control circuit 259 become unnecessary, the circuit may be simplified and the circuit size may be also reduced.

Note that, usually, in the frequency divider circuit, a high-speed operation is needed, in particular, for the frequency divider in the first stage that directly receives and frequency-divides the output signal from the VCO. Moreover, in the PLL in a millimeter waveband or the like, the operation speed of the frequency divider in the first stage may be a limiting factor of the entire operation frequency of the PLL.

Therefore, in the PLL circuit 20 according to the present technology, in the frequency divider circuit 24 including a plurality of frequency dividers connected in multi stages, the injection locked frequency divider 24-1 is arranged in the frequency divider in the first stage that directly receives the output signal of the VCO 23, thereby achieving a high-speed operation.

Next, variants of the embodiment are described.

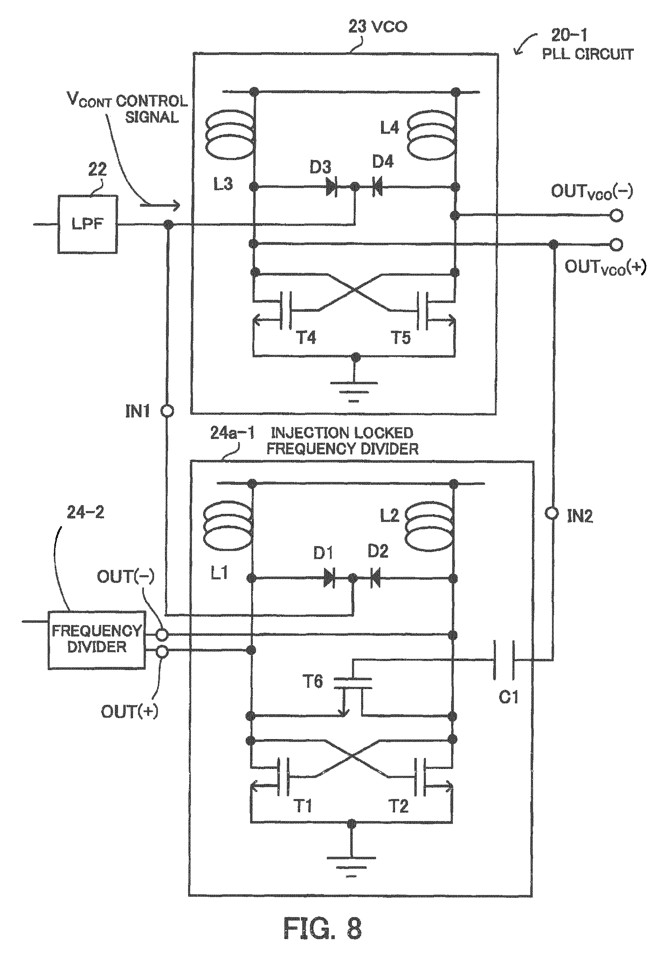

FIG. 8 illustrates a first variant of the PLL circuit of the embodiment. A circuit example of the VCO 23 and an injection locked frequency divider 24a-1 in a PLL circuit 20-1 of a first variant and an example of the peripheral connection are illustrated.

The injection locked frequency divider 24a-1 includes the inductors L1 and L2, diodes D1 and D2, transistors T1, T2, and T6 (N-channel MOS FETs), and the capacitor C1. Moreover, the VCO 23 includes the inductors L3 and L4, diodes D3 and D4, and transistors T4 and T5. Note that, the transistors T1, T2, and T6 correspond to the first, second, and third transistors, respectively.

The relation of connection between the respective elements is described. One end of the inductor L3 is connected to one end of the inductor L4 and the power supply line. The other end of the inductor L3 is connected to the anode of the diode D3, the output terminal OUT_{vco}(+), one end of the capacitor C1, the drain of the transistor T4, and the gate of the transistor T5.

The other end of the inductor L4 is connected to the anode of the diode D4, the output terminal OUT_{vco}(-), the drain of the transistor T5, and the gate of the transistor T4.

The sources of the transistors T4 and T5 are connected to GND. The output terminal of the LPF 22 is connected to the cathode of the diode D3 and the cathode of the diode D4. Furthermore, the output terminal of the LPF 22 is connected to the cathode of the diode D1 and the cathode of the diode D2 via the input terminal IN1.

On the other hand, one end of the inductor L1 is connected to one end of the inductor L2 and the power supply line. The other end of the inductor L1 is connected to the anode of the diode D1, one input terminal of the frequency divider 24-2 via the output terminal OUT (+), the drain of the transistor T1, the gate of the transistor T2, and the source of the transistor T6.

The other end of the inductor L2 is connected to the anode of the diode D2, the other input terminal of the frequency divider 24-2 via the output terminal OUT(-), the drain of the transistor T2, the gate of the transistor T1, and the drain of the transistor T6.

The sources of the transistors T1 and T2 are connected to GND. The gate of the transistor T6 is connected to the other end of the capacitor C1.

Also in the first variant as described above, the operation frequency of the injection locked frequency divider 24a-1 may be expanded, so that a wideband PLL operation may be achieved.

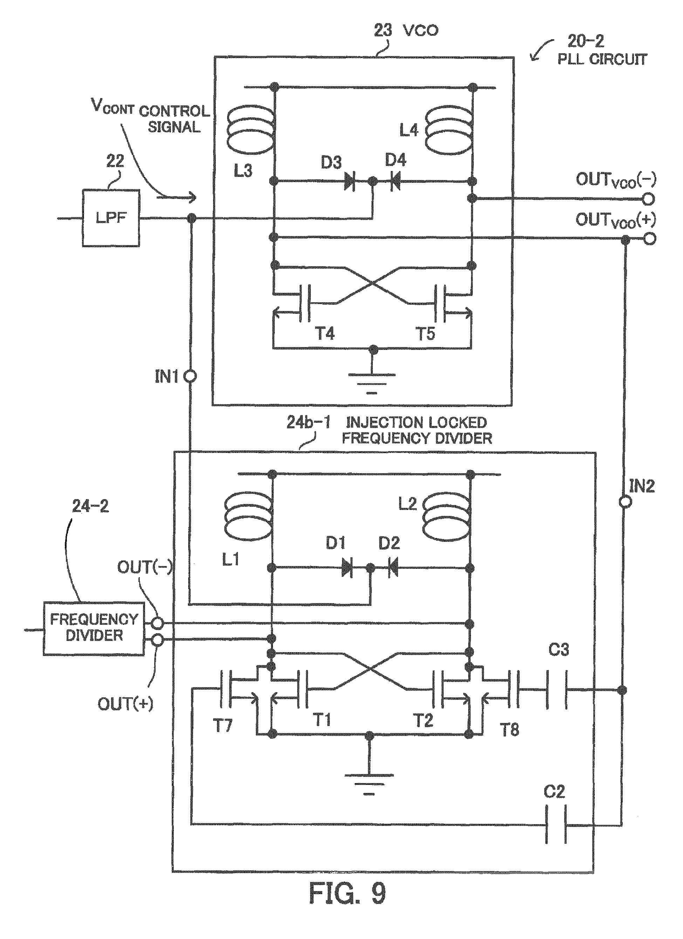

FIG. 9 illustrates a second variant of the PLL circuit of the embodiment. A circuit example of the VCO 23 and an injection locked frequency divider 24b-1 in a PLL circuit 20-2 of the second variant and an example of the peripheral connection are illustrated.

The injection locked frequency divider 24b-1 includes the inductors L1 and L2, diodes D1 and D2, transistors T1, T2, T7, and T8 (N-channel MOS FETs), and the capacitors C2 and C3. Moreover, the VCO 23 includes the inductors L3 and L4, diodes D3 and D4, and transistors T4 and T5. Note that, the transistors T1, T2, T7, and T8 correspond to the first, second, third, and fourth transistors, respectively.

The relation of connection between the respective elements is described. One end of the inductor L3 is connected to one end of the inductor L4 and the power supply line. The other end of the inductor L3 is connected to the anode of the diode D3, the output terminal OUTvco(+), one ends of the capacitor C2 and the capacitor C3, the drain of the transistor T4, and the gate of the transistor T5.

The other end of the inductor L4 is connected to the anode of the diode D4, the output terminal OUTvco(-), the drain of the transistor T5, and the gate of the transistor T4.

The sources of the transistors T4 and T5 are connected to GND. The output terminal of the LPF 22 is connected to the cathode of the diode D3 and the cathode of the diode D4. Furthermore, the output terminal of the LPF 22 is connected to the cathode of the diode D1 and the cathode of the diode D2 via the input terminal IN1.

On the other hand, one end of the inductor L1 is connected to one end of the inductor L2 and the power supply line. The other end of the inductor L1 is connected to the anode of the diode D1, one input terminal of the frequency divider 24-2 via the output terminal OUT(+), the drain of the transistor T1, the drain of the transistor T7, and the gate of the transistor T2.

The other end of the inductor L2 is connected to the anode of the diode D1, the other input terminal of the frequency divider 24-2 via the output terminal OUT(-), the drain of the transistor T2, the drain of the transistor T8, and the gate of the transistor T1.

The sources of the transistors T1, T2, T7, and T8 are connected to GND. The gate of the transistor T7 is connected to the other end of the capacitor C3, and the gate of the transistor T8 is connected to another end of the capacitor C2.

Also in the second variant as described above, the operation frequency of the injection locked frequency divider 24b-1 may be expanded, so that a wideband PLL operation may be achieved.

As described above, according to the embodiments and variants, an injection locked frequency divider may be applied to a wideband PLL circuit without using any complicated adjustment circuit, so that a stable and high-speed operation of a PLL circuit may be achieved.

The disclosed PLL device enables a wideband PLL operation.

## Claims

1. A PLL device comprising:
a variable frequency oscillator (13, 23) configured to vary an oscillation frequency in response to a control signal including information on a phase difference between a reference signal and a frequency division signal and oscillate an output signal obtained by multiplying a frequency of the reference signal; and
a frequency divider section (14, 24) configured to frequency-divide the output signal to generate the frequency division signal, wherein
an injection locked frequency divider (14a, 24-1) is arranged in the frequency divider section, the control signal is input to the injection locked frequency divider, and an operation frequency of the injection locked frequency divider is controlled by the control signal.

2. The PLL device according to claim 1, wherein the injection locked frequency divider oscillates at an operation frequency at which a ratio of an output frequency change per unit voltage of the variable frequency oscillator to an operation frequency change per unit voltage of the injection locked frequency divider is in a proportional relation to a frequency division ratio of the injection locked frequency divider.

3. The PLL device according to claim 1 or 2, wherein the frequency divider section includes a plurality of frequency dividers (240a-1, 240-2 to 240-n) connected in multiple stages, and the injection locked frequency divider is arranged in a frequency divider in the first stage which directly receives the output signal of the variable frequency oscillator.

4. The PLL device according to claim 1, 2 or 3, wherein the injection locked frequency divider includes:
an oscillation section (L1, L2, D1, D2, T1, and T2) configured to oscillate a differential output, the oscillation section including: an inductor section (L1, L2) having a plurality of inductors connected in series; a variable capacitance section (D1, D2) connected in parallel to the inductor section and configured to vary a capacitance value by inputting of the control signal; and a negative resistance section (T1, T2) connected in parallel to the inductor section and configured to generate a negative resistance; and
a switch element (T3) configured to switch and frequency-divide the differential output in response to an input level.

5. The PLL device according to claim 4, wherein the inductor section includes a first inductor and a second inductor (L1, L2), and one end of the first inductor and one end of the second inductor are connected to a power supply line, wherein
the variable capacitance section includes a first diode and a second diode (D1, D2), a cathode of the first diode and a cathode of the second diode are connected to each other, and the control signal is input to a common cathode connection point, wherein
the negative resistance section includes an N-channel type first transistor (T1) and an N-channel type second transistor (T2) which are cross-coupled, a drain of the first transistor is connected to another end of the first inductor, an anode of the first diode, a gate of the second transistor, and a first differential output terminal, and a drain of the second transistor is connected to another end of the second inductor, an anode of the second diode, a gate of the first transistor, and a second differential output terminal, and wherein
the switch element is an N-channel type third transistor (T3), a drain of the third transistor is connected to sources of the first transistor and the second transistor, a source of the third transistor is connected to GND, and the output signal of the variable frequency oscillator is input to a gate of the third transistor.

6. The PLL device according to claim 4, wherein the inductor section includes a first inductor and a second inductor (L1, L2), and one end of the first inductor and one end of the second inductor are connected to the power supply line, wherein
the variable capacitance section includes a first diode and a second diode (D1, D2), a cathode of the first diode and a cathode of the second diode are connected to each other, and the control signal is input to a common cathode connection point, wherein
the negative resistance section includes an N-channel type first transistor (T1) and an N-channel type second transistor (T2) which are cross-coupled, wherein
the switch element is an N-channel type third transistor (T6), wherein
a drain of the first transistor is connected to another end of the first inductor, an anode of the first diode, a gate of the second transistor, a first differential output terminal, and a source of the third transistor, wherein
a drain of the second transistor is connected to another end of the second inductor, an anode of the second diode, a gate of the first transistor, a second differential output terminal, and a drain of the third transistor, and wherein
sources of the first transistor and the second transistor are connected to GND, and the output signal of the variable frequency oscillator is input to a gate of the third transistor.

7. The PLL device according to claim 4, wherein the inductor section includes a first inductor and a second inductor (L1, L2), and one end of the first inductor and one end of the second inductor are connected to the power supply line, wherein
the variable capacitance section includes a first diode and a second diode (D1, D2), a cathode of the first diode and a cathode of the second diode are connected to each other, and the control signal is input to a common cathode connection point, wherein
the negative resistance section includes an N-channel type first transistor (T1) and an N-channel type second transistor (T2) which are cross-coupled, wherein
the switch element includes an N-channel type third transistor (T7) and an N-channel type fourth transistor (T8), wherein
a drain of the first transistor is connected to another end of the first inductor, an anode of the first diode, a gate of the second transistor, a first differential output terminal, and a drain of the third transistor, wherein
a drain of the second transistor is connected to another end of the second inductor, an anode of the second diode, a gate of the first transistor, a second differential output terminal, and a drain of the fourth transistor, and wherein
sources of the first to fourth transistors are connected to GND, one differential output signal of the variable frequency oscillator is input to a gate of the third transistor, and another differential output signal of the variable frequency oscillator is input to a gate of the fourth transistor.
